(19)

Europäisches
Patentamt
European
Patent Office
Office européen
des brevets

(11)     EP 2 627 997 B1

(12)     **EUROPEAN PATENT SPECIFICATION**

(45) Date of publication and mention
of the grant of the patent:
**06.12.2017  Bulletin 2017/49**

(21) Application number: **11784807.7**

(22) Date of filing: **12.10.2011**

(51) Int Cl.:
**G01N 27/02** *(2006.01)*

(86) International application number:
**PCT/NO2011/000291**

(87) International publication number:
**WO 2012/050460 (19.04.2012 Gazette 2012/16)**

(54) **WATER CONTENT MEASURING APPARATUS**

VORRICHTUNG ZUR MESSUNG DES WASSERGEHALTS

APPAREIL DE MESURE DE TENEUR EN EAU

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.10.2010  NO 20101411**

(43) Date of publication of application:
**21.08.2013  Bulletin 2013/34**

(73) Proprietor: **Hammertech AS
5899 Bergen (NO)**

(72) Inventor: **HAMMER, Erling, A.
N-5718 Frekhaug (NO)**

(74) Representative: **D Young & Co LLP
120 Holborn
London EC1N 2DY (GB)**

(56) References cited:
**WO-A1-03/050529          WO-A1-2004/025288
WO-A2-2007/109772     US-A- 3 946 308
US-A- 5 585 729**

## Description

### Field of the invention

The present invention relates to water content measuring apparatus, for example to a water content measuring apparatus for monitoring water content in fluid flows, for example for monitoring water content in fluid flows wherein conditions for hydrate deposit formation can potentially arise. Moreover, the present invention relates to methods of measuring water content in fluid flows, for example to methods of measuring water content in fluid flows in conditions wherein hydrate deposit formation can potentially arise. Furthermore, the present invention concerns software products recorded on machine-readable media, wherein the software products are executable on computing hardware for implementing aforesaid methods.

### Background of the invention

It is known to employ a pair of coils of wire exhibiting mutually different responses and excited with alternating signals for determining phase characteristics of a fluid region intersected by magnetic and electrical fields generated by the pairs of coils when excited. Such coils conventionally have relatively few turns, for example less than 10 turns each, and can determine fluid composition to within an accuracy of a few percent by way of measurement of their resonance characteristics, for example resonance Q-factor. The pair of coils is susceptible, for example, to being used to monitor fluids extracted from a production borehole when water, oil, sand particles and scum can potentially simultaneously be present in the fluids. Apparatus for determining phase characteristics of a fluid region are described in a published international PCT application no. WO2004/025288A1, "Method and arrangement for measuring conductive component current of a multiphase fluid flow and uses thereof", inventor Erling Hammer. WO03/050529 discloses a further apparatus for the analysis of multiphase fluid flow. A contemporary issue is that geological oil reserves are becoming rapidly depleted, requiring oil companies to revert to difficult and expensive off-shore drilling and production to meet World demand for oil; the World demand is presently estimated to be 85 million barrels of oil equivalent per day. Many newly discovered oil and gas fields, for example in the Barents Sea lying North of Norway, are found to contain a higher ratio of gas to oil than expected from earlier discovered oil and gas fields. Consequently, there is found to be a need to monitor to an increasing extent gas production in Northern latitudes which are often subjected to severe operating conditions, for example low ambient operating temperatures, for example below 0 °C.

A contemporary problem encountered with gas production is spontaneous formation of hydrate deposits which can block tubes completely and therefore threaten gas production with associated financial loss. Hydrate formation occurs when gas hydrocarbon molecules, for example on account of strong polarization of their hydrogen atoms, attract oxygen atoms of water molecules so that the hydrocarbon molecules become encapsulated in water molecules to form miniature hydrate ice crystals which can precipitate to cause aforementioned hydrate deposit blockages in tubes. The blockages grow initially on inside walls of tubes, and eventually obstruct a central region of the tubes. Once hydrate ice crystal deposition commences on the inside walls, hydrate crystal nucleation is enhanced such that hydrate blockages can potentially form rapidly, for example within minutes. Moreover, the blockages are also often rather difficult to remove when formed, sometimes requiring costly "pigging" or heat treatment to be performed. A conventional approach to hinder hydrate formation is to include additives in a flow of gas. However, using additives is expensive and can also potentially cause a degree of contamination in gas flows.

Contemporary sensors and associated measuring instruments for sensing hydrate formation in tubes are complex and costly, thereby limiting locations whereat they can be installed in gas production systems. Consequently, many locations along gas tubes and pipes which could beneficially be provided with measuring instruments capable of detecting potential formation of hydrate deposits are hindered from being accordingly equipped on account of cost of conventional hydrate measuring instruments.

### Summary of the invention

The present invention seeks to provide a more cost effective and robust water content measuring apparatus, for example for detecting conditions under which hydrate deposits are potentially susceptible to arise.

The invention is of advantage in that the apparatus is capable of measuring minute quantities of water present within the tube, for example indicative of potential early hydrate formation. Further aspects of the invention are defined in the appended claims.

### Description of the diagrams

Embodiments of the present invention will now be described, by way of example only, with reference to the following diagrams wherein:

FIG. 1      is an illustration of an embodiment of a water content measuring apparatus pursuant to the present invention;

FIG. 2      is an illustration of signals to be analyzed in the apparatus of FIG. 1;

FIG. 3A      is an illustration of a signal received from a pickup coil of the apparatus of FIG. 1 when a fluid flow tube of the apparatus is devoid of water;

FIG. 3B      is an illustration of a signal received from the pickup coil of the apparatus of FIG. 1 when the fluid flow tube of the apparatus contains spring water;

FIG. 4      is an illustration of changes in a parameter (*tau, τ*) representative of Q-factor as a function of a water content of the fluid flow tube of the apparatus of FIG. 1;

FIG. 5      is a graph illustrating sensitivity of the apparatus of FIG. 1 to saline solution;

FIG. 6      is a graph illustrating sensitivity of the apparatus of FIG. 1 to salt weight in saline solution present within a sensing tube of the apparatus;

FIG. 7      is a schematic illustration of noise sources of a water content measuring apparatus pursuant to the present invention;

FIG. 8      is a schematic illustration of an electronic circuit for use when implementing a water content measuring apparatus pursuant to the present invention;

FIG. 9      is an illustration of a resonance characteristic of a sensing resonant coil arrangement of the apparatus associated with FIG. 7 and FIG. 8, illustrating a driven resonance $\omega_0$ and an undriven natural resonance $\omega_n$;

FIG. 10      is an illustration of a sample of measured Q-factors of a sensing coil arrangement of the apparatus associated with FIG. 7 and FIG. 8; and

FIG. 11      is an illustration of a resonance characteristic of a sensing coil arrangement of the apparatus associated with FIG. 7 and FIG. 8.

In the accompanying diagrams, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

## Description of embodiments of the invention

It is well known that cylindrical conductor coils exhibit electrical resonances on account of inductance and distributed capacitances associated with such conductor coils; such "distributed capacitances" contributed to resonant circuit tuning capacitors pursuant to the present invention. The distributed capacitances correspond to inter-winding capacitances. Moreover, the inductance arises on account of magnetic flux developed by the coils. However, as aforementioned, it is conventionally perceived that such coils are only capable of providing multiphase mixture measurement to an error deviation of a few percent. For measuring conditions of potential hydrate formation, it is necessary to measure water content to concentrations of a few parts per million (p.p.m.). Thus, it has been conventional practice to regard an electrical resonance coil as being quite unsuitable for use in making precision hydrate-related measurements.

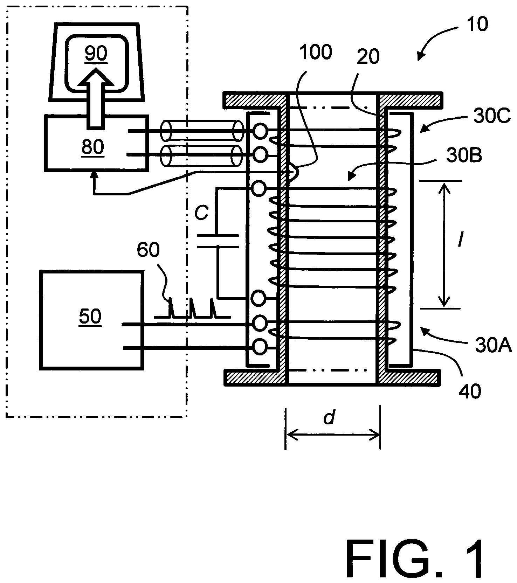

Experimental studies associated with devising the present invention have surprisingly shown that suitable excitation of a coil having a sufficient number of turns and an adequate length in relation to its diameter allows water content measurements to be performed to concentrations as low as a few parts per million (p.p.m.). Such high accuracy measurement is feasible utilizing a water content measurement apparatus as illustrated in FIG. 1; the water content measurement apparatus is indicated generally by **10.** The apparatus **10** includes a polymer material tube **20,** for example fabricated from polycarbonate, acrylic-type or PEEK plastics materials; such polymer materials are chosen to exhibit relatively low dielectric losses at a frequency of several MHz. The tube **20** beneficially has an inside diameter *d* in a range of 70 to 90 mm, and a length provided with windings in a range of 280 mm to 320 mm; however, the apparatus **10** is susceptible to being adapted at larger diameters above 90 mm. The tube **20** is provided at its first end with an excitation coil **30A** comprising a single turn. In a middle portion of the tube **20,** there is provided a resonance coil **30B** comprising in a range of 30 to 50 turns which is optionally terminated with a capacitor C of value 32 pF; for example, 34 turns for the coil **30B** is found to function well in practice. The capacitor C is beneficially a high-quality capacitor exhibiting low dielectric losses at operating frequencies of a few MHz, for example a high-quality ceramic capacitor, Mica dielectric capacitor or sealed air-cored capacitor. The resonance coil **30B** coupled to its associated capacitor C is operable to exhibit a resonance frequency in an order of a few MHz, for example in a range of 1 MHz to 5 MHz, although other operating frequencies can be employed if required. The resonance coil **30B** is beneficially uniformly wound along the length /, such that the coil **30B** has a diameter:length ratio in a range of 1:3 to 1:5. Ratios in excess of 1:5 can optionally be employed. Beneficially, the coil **30B** is wound from Litz wire (namely individually insulated wire strands) or from thin Copper tape with associated insulation to reduce conductor skin-depth effects in the coil **30B** from adversely affecting its Q-factor to detriment of sensitivity of the apparatus **10** to minute quantities of water present in the tube **20.** Optionally, an outer conducting surface of windings of the coil **30B** is silver plated to increase a resonance Q-factor of the coil **30B.** Moreover, the tube **20** also includes a pickup coil **30C** comprising a single turn. The capacitor *C* is beneficially spatially located in close proximity to the coil **30B** as illustrated for obtaining most accurate measurement of water content, for example in gases flowing in operation through the tube **20** in conditions in which hydrate deposition would be expected to arise. The tube **20** and its coils **30A, 30B, 30C** are furnished with an outer peripheral screening shield **40** fabricated from Aluminium sheet, stainless steel or similar. Beneficially, the shield is designed to be able to withstand a pressure that is likely to be encountered within the tube 20. Optionally, the Aluminium sheet employed to fabricate the shield 40 has a thickness which is less than 1 mm, for preferably less than 0.5 mm. Alternatively, or additionally, outer fibre glass or carbon composite shielding for the tube 20 and its coils 30A, 30B, **30C** is employed.

The excitation coil 30A is coupled to a generator 50 which is operable, for example, to output a temporal series of pulses **60** having a pulse duration $\tau_p$ and a pulse repetition frequency $f_p$. Beneficially, the pulse duration $\tau_p$ is much shorter than a period between pulses **60,** namely $\dfrac{1}{f_p}$ by at least an order of magnitude.

The pickup coil **30C** is connected via two well-screened coaxial cables **70** to a signal processing unit **80** employing computing hardware executing software products for analyzing signals induced in operation in the pickup coil **30C** to generate corresponding analysis results. The processing unit **80** is operable to present the analysis results on a display **90** indicative of concentration of water content present within the tube **20,** for example potentially to trace levels as low as a few parts per million (p.p.m.) of water content being present within the tube **20.** Optionally, the processing unit **80** is adapted to monitor water concentration, temperature and conductivity on an inside surface of the tube **20** for identifying conditions in which hydrate deposition is likely to arise.

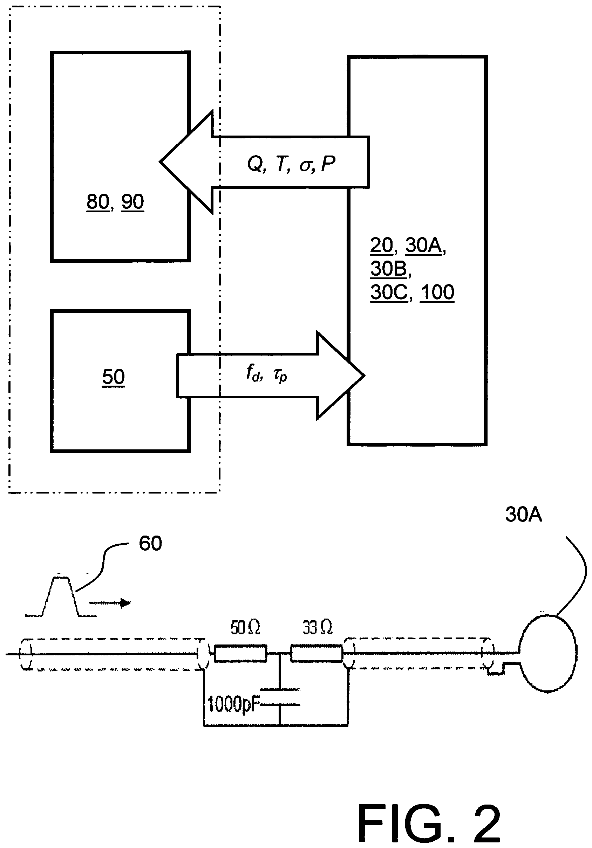

Resonance characteristics of the coil **30B** are strongly affected depending upon whether or not water present within the tube **20** is saline in nature. Salt content in a salt solution affects a freezing temperature of the solution, and therefore affects a temperature at which hydrate deposition can arise when the solution is present together with a hydrocarbon, for example methane or propane. On account of the highly conductive nature of saline solution, it is necessary for the apparatus **10** to include additionally a sensor arrangement **100** on an inside surface of the tube **20,** wherein the sensor arrangement **100** includes a temperature sensor for measuring a temperature *T* of the inside surface of the tube **20** and a surface electrical conductivity sensor for measuring an electrical conductivity $\sigma$ of a film formed in operation of the inside surface of the tube **20.** Signals associated with the sensor arrangement **100** conveyed to the processing unit **80** are illustrated in FIG. 2. The processing unit **80** is programmed to perform a computation represented by Equation 1 (Eq. 1):

$$w = F(Q, f_r, T, \sigma, P) \qquad\qquad \text{Eq. 1}$$

wherein

$w$ = water concentration;
$P$ = pressure within the tube **20;**
$Q$ = Q-factor of resonance of the coil **30B** subject to excitation;
$T$ = temperature of inside surface of the tube **20;**
$\sigma$ = electrical low-frequency or d.c. conductivity of a moisture film formed on the inside surface of the tube **20;** and
$F$ = a conversion function determined from experimental calibration measurements.

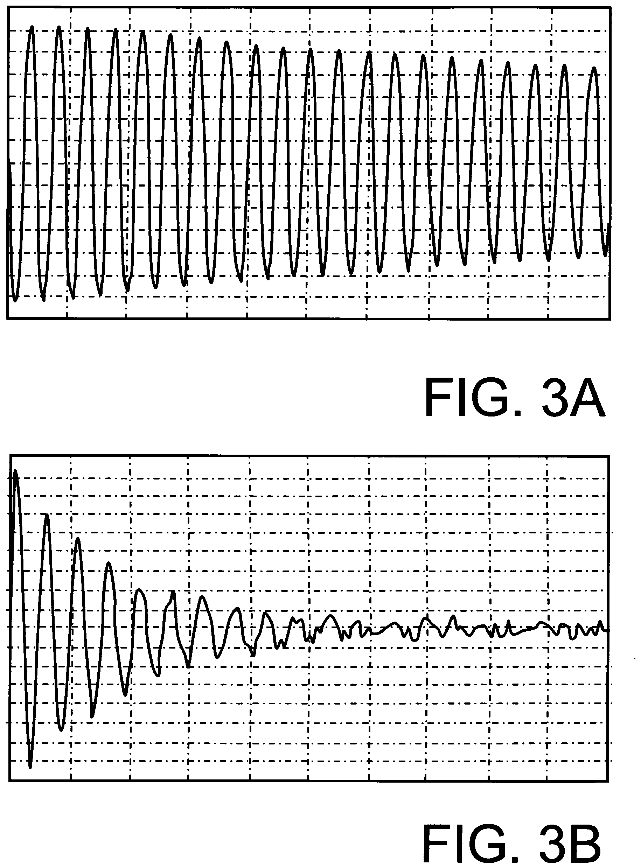

The function *F* is beneficially implemented as a lookup table implemented in computer memory of the processing unit **80.** Optionally, the function *F* is determined empirically by performing a series of experimental tests to derive measurement data, and then synthesizing intermediate measurements by mathematical extrapolation to provide the function *F* as a continuously variable function. Alternatively, the function *F* can be derived analytically from theoretical consideration of the sensor arrangement **100.** The Q-factor *Q* is determined from an envelope of a temporal signal decay characteristic as illustrated in FIG. 3A and FIG. 3B wherein the signal is described substantially by Equation 2 (Eq. 2):

$$s = v_0 e^{\frac{t}{\tau}} \sin \omega t \qquad\qquad \text{Eq. 2}$$

wherein

$s$ = signal induced in the pickup coil **30C;**

$v_0$ = amplitude coefficient of the signal $s$;

$\tau$ = exponential decay time constant of the response signal arising from electrical resonance of the coil **30B;**

$\omega$ = resonance frequency of the coil **30B;** and

$t$ = time.

The sensor arrangement **100** can be implemented in various different ways. For example electrodes of the sensor arrangement **100** for measuring electrical conductivity can be implemented as annular ring electrodes around an inner circumferential surface of the tube **20** and disposed in a direction along an elongate axis of the tube **20.** Alternatively, or additionally, electrodes of the sensor arrangement **100** for measuring electrical conductivity can be implemented as sectors of limited angular extent for sensing inhomogeneous deposition of hydrates onto the inner surface of the tube **20.** Beneficially, the conductivity sensing electrodes are selected or treated to have a similar wetting characteristic to other parts of the tube **20** so that hydrate formation measurements provided by the apparatus **10** are as representative as possible for other tube connected to the tube **20.** Similarly, the temperature sensor of the sensor arrangement **100** can be implemented as one or more individual temperature sensors which are spatially disposed for sensing temperature gradients within the tube **20.** For purposes of computing Equation 1 (Eq. 1), an aggregate or average of the several temperature measurements from a plurality of temperature sensors of the sensing arrangement **100** can be used. The inside surface of the tube **20** is beneficially smooth for avoiding non-representative deposition of hydrate deposits onto the inside surface.

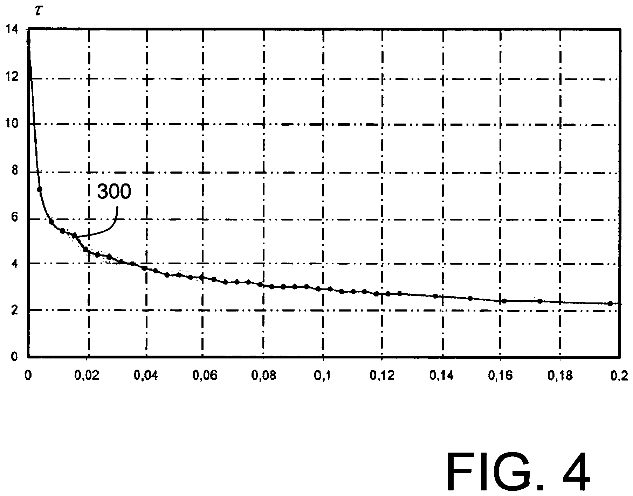

FIG. 3A and FIG. 3B are illustrations of resonance characteristics exhibited by the coil **30B** as sensed using the pickup coil **30C.** In a preferred embodiment of the invention, the coil **30B** beneficially has 34 turns and is optionally tuned with a capacitor $C$ having a capacitance value 32 pF. Alternatively, the coil **30B** has 15 turns and is optionally tuned with a capacitor $C$ having a capacitance value 100 pF. Correct impedance matching of the excitation coil **30A** is highly beneficial for obtaining an uncluttered waveform as presented in FIG. 3A and FIG. 3B; the impedance matching corresponds to a filter which reduces excitation of higher-order resonances within the coil **30B,** for example at frequencies approximately an order of magnitude above its main resonance frequency, for example at around 35 MHz when the coil **30B** has a fundamental resonance around 3.5 MHz. Matching components as illustrated in FIG. 2 including a T-arrangement comprising a series connection of 50 $\Omega$, 33 $\Omega$ resistors and a1000 pF capacitor to signal ground at a midpoint between the resistors has been found from experimental studies to function well for the apparatus **10.** A relatively high Q-factor resonance of FIG. 3A corresponds to the tube **20** devoid of water; in contrast, FIG. 3B corresponds to a lower Q-factor response arising when the tube **20** contains a quantity of fresh water. By accurate measurement of Q-factor executed by the processing unit **80** when processing the pickup signal from the pickup coil **30C,** the apparatus **10** is capable of detecting very small concentrations of water within the tube **20,** for example to concentrations of a few parts per million (p.p.m.). The very high sensitivity of the apparatus **10** is also illustrated in FIG. 4 which is a graph having an abscissa axis representative of water fraction $\beta$ present within the tube **20,** and an ordinate axis providing a measured parameter (*tau,* $\tau$) indicative of the Q-factor of resonance of the coil **30B** a sensed via the pickup coil **30C.**

As will be elucidated in greater detail later, by exciting the coil **30B** to resonate, there is providing thereby an indication, via Q-factor measurement pursuant to the present invention, for establishing whether or not hydrate formation is likely to occur within a region encircled by the coil **30B.** The Q-factor measurement is beneficially determined from a natural undriven Q-factor of the coil **30B,** namely without disturbances arising from a finite driving impedance of the excitation coil **30A.** The pickup coil **30C** is beneficially arranged to represent a high impedance to the coil **30B,** and thereby has a negligible influence upon the resonance of the coil **30B.** Beneficially, the excitation coil **30A** is driven momentarily to excite the coil **30B** into resonance, and then the resonance of the coil **30B** is allowed to decay naturally with the excitation coil **30A** "open circuit" so that the excitation coil **30A** does not influence the Q-factor of the coil **30B,** namely permits the coil **30B** to exhibit its natural resonance having a natural resonant frequency $\omega_n$. By monitoring the natural resonance of the coil **30B,** an improved measurement accuracy can be achieved from the apparatus **10.** In the apparatus **10,** the Q-factor measurement of the coil **30B** can either be performed in a continuous driven manner or in a pulse-resonant excited manner, or by employing a mixture of such measurement techniques.

The apparatus **10** provides a benefit that its pulse excitation manner of operation enables the generator **50** and the data processor **80** to be located spatially remotely from the tube **20** and its associated coils **30A, 30B, 30C** and optional sensor arrangement **100.** Such flexibility is highly beneficial when the tube **20** is required to operate at temperatures which would be hostile to electronic components associated with the data processor **80** and the generator **50.** The apparatus **10** is susceptible to being employed in a large range of applications. For example, the apparatus **10** can be used in ocean-bed hydrate handling equipment, in separation tanks, down boreholes, in carbon dioxide capture and sequestration systems associated with climate change carbon tax funded facilities, in chemical industries, in space probes and similar. Measurement methods employed in the apparatus **10** will be described in more detail later.

It will be appreciated that the apparatus **10** is not operable to measuring a presence of hydrate deposits directly, but rather is able to provide an indication of a likelihood of hydrate deposit formation (hydrate ice crystals) based upon measured conditions of conductivity, temperature and pressure in combination with determining a concentration of water present within the tube **20.** Optionally, the generator **50** is operable to excite the coil **30A** by way of a repetitive burst of a plurality of pulses as an alternative to periodic single pulses; such burst excitation enables a better signal-to-noise (S/N) to be achieved in relation to electronically-generated noise arising within the apparatus **10,** in combination with a reduced tendency to excite higher order resonances within the coil **30B.**

In FIG. 1, the peripheral screening shield **40** is described in the foregoing as being fabricated from Aluminium. Alternatively, the screen **40** is fabricated from a recognized type of steel which is able to withstand gas and liquids which the apparatus **10** will encounter during transportation and operation. A region between an outside surface of the tube **20** and the screen **40** is beneficially filled with a mechanical robust insulating material exhibiting a relative permeability of approximately unity; for example the coils **30A, 30B, 30C** can beneficially be appropriately encapsulated (namely "potted") in a hydrocarbon polymer materials resin, for example an epoxy or polyurethane material. Optionally, the screen **40** includes fibre glass, carbon fibre or other strong polymer structural components, for example fabricated from stainless steel which can withstand a pressure within the tube **20** and thereby enable the instrument **10** to survive structurally in an unlikely event that the tube **20** ruptures in operation.

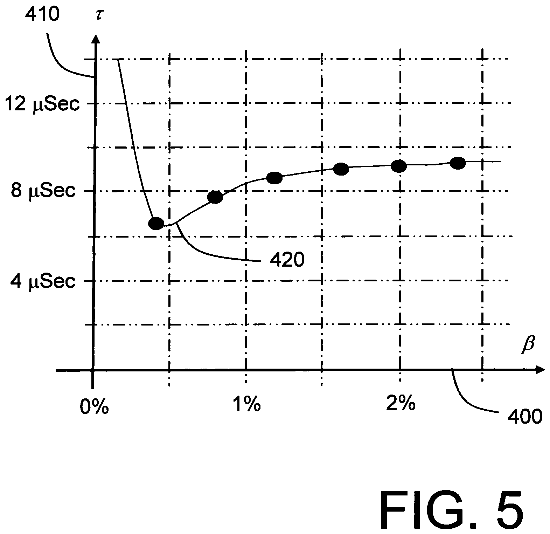

Referring again to Equation 1 (Eq. 1), the apparatus **10** operates to measure subtle characteristics whose nature is not generally appreciated. For example, a kink **500** in the curve of FIG. 4 is not a measurement inaccuracy, but rather a genuine relaxation effect resulting from spontaneous momentary alignments of groups of polarized water molecules to form larger momentary dipole moments which are many orders of magnitude larger than the dipole moments of individual water molecules. Such larger dipole moments are observed in the formation of ice crystals. In FIG. 5, there is a shown a graph pertaining to the Q-factor exhibited by the coil **30B** as a proportion of saline solution within the tube **20** is varied. An abscissa axis **400** denotes a percentage of saline solution present in the tube **20** and an ordinate axis **410** denoting the time constant *tau, $\tau$* of resonance of the coil **30B;** the Q-factor Q of the coil **30B** is directly susceptible to being computed from the time constant *tau, $\tau$.* It will be observed in FIG. 5 that a minimum Q-factor occurs at a saline proportion $\beta$ of around 0.5% with a high sensitivity below 0.5%, namely below 5000 p.p.m., wherein discrimination of presence of saline solution to within tens' of p.p.m. is achievable using the apparatus **10.**

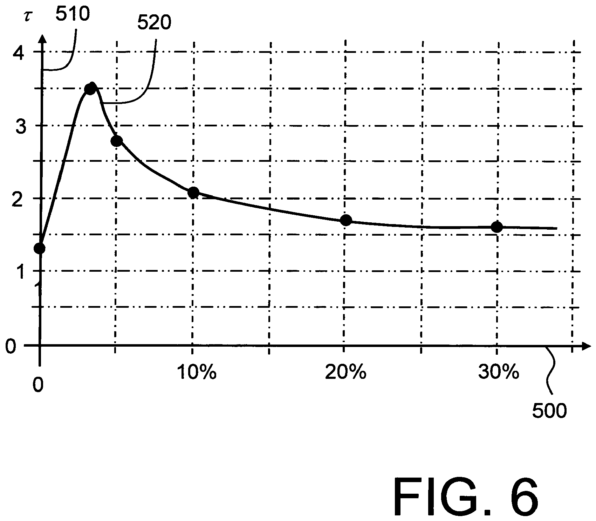

In FIG. 6, a response of the apparatus **10** to saline solution within the tube **20** is shown, wherein an abscissa axis **500** denotes percentage weight of salt within a saline solution present within the tube **20,** and an ordinate axis **510** denotes the time constant *tau, $\tau$.* The resonance characteristic of the coil **30B** exhibits a distinct peak **520** at around 3% salt (Sodium Chloride, *NaCl*) by weight present in the solution corresponding to greatest Q-factor, reducing with salt percentage above 3% as conductivity of the solution increases and also falling for concentrations below 3% on account of aforementioned relaxation effects caused by spontaneous momentary polarisation alignment of water molecules to create a large effective dipole moment. Between 0% salt weight content and 3% salt weight content, increasing salt content hinders spontaneous association of water molecules to form a large momentary effective dipole moment by way of Chlorine atoms screening highly polarized hydrogen atoms (protons), thereby resulting in a corresponding progressive increase in Q-factor. Both FIG. 5 and FIG. 6 exhibit a rapidly changing measurement characteristic near zero which imparts the apparatus **10** with excellent measurement characteristics for trace amounts of fresh water or saline solution. Such a measurement characteristic is well suited for identifying conditions where there is a potential risk of hydrate deposits being formed which can block tubes, for example in an offshore gas production and processing facility.

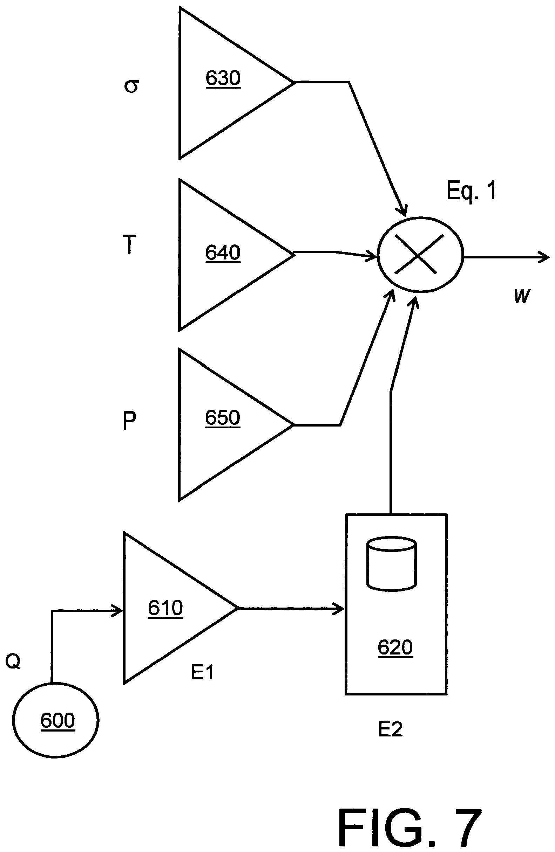

In FIG. 7, sources of noise arising within the apparatus **10** are illustrated schematically. These noise sources influence an accuracy to which the Q-factor of the coil **30B** can be measured. The Q-factor of the coil **30B** is greatest when its encircled region is filled with dry gas; this is conveniently referred to as being $Q_{dry}$. When traces of fresh water or saline water are introduced into the encircled region, the Q-factor of the coil **30B** is reduced; this is conveniently referred to as being $Q_{wet}$. The Q-factor $Q_{dry}$ is influenced by the temperature *T,* for example as a result of winding resistances of the coil **30B** changing with the temperature *T.* Thus, inherent in Equation 1 (Eq. 1) is a subtraction function as described in Equation 3 (Eq. 3):

$$w = F((Q_{dry}(T) - Q_{wet}(T)), f_r, T, \sigma, P) \qquad \text{Eq. 3}$$

$Q_{dry}(T)$ can be determined by accurate measurement. $Q_{wet}(T)$ is determined as the apparatus **10** is employed in practice. It will be appreciated that $Q_{dry}$ and $Q_{wet}$ can be relatively large numbers, for example in an order of 100 or more, and hence need to be measured to high precision for detecting occurrence of water to a sensitivity in an order of p.p.m. Such precision is influenced by noise and drift effects occurring within the apparatus **10** when in use.

In FIG. 7, the sources of noise occurring within the apparatus **10** include a first noise source **600** affecting the Q-factor arising from flow turbulence within a spatial region surrounded by the tube **20** surrounded by the coil **30B.** Such flow turbulence is quasi-constant within a time period of signal decay illustrated in FIG. 3A and FIG. 3B, but will vary from one measurement of Q-factor of the coil **30B** to another thereof over a monitoring period of several seconds or minutes, for example. Electronic noise *E1* arising in an electronic amplifier **610** receiving signals from the pickup coil **30C** arises, but is relatively constant; however, the electronic noise *E1* is influenced by an operating temperature of the amplifier **610**. Beneficially, the amplifier **610** is cooled by Peltier elements or a cryogenic engine to reduce its electronic noise *E1.* Digital electronic circuits **620** which receive an output signal from the amplifier **610** cause electronic noise *E2,* for example quantization noise, which is beneficially reduced by suitable design choice of components, for example by employing high-resolution ADC components for converting amplified analog signals from the amplifier 610 into corresponding digital sampling data. Noise sources **630, 640, 650** are associated with conductivity measurements, temperature measurements and pressure measurements respectively and can arise from corrosion (i.e. drift effects), electrochemical effects and ageing of electronic components. In practice, the noise source **600** is dominant and beneficially requires novel approaches to measurement technique pursuant to the present invention to obtain p.p.m. measurement accuracy results when detecting a presence of water within the tube **20**.

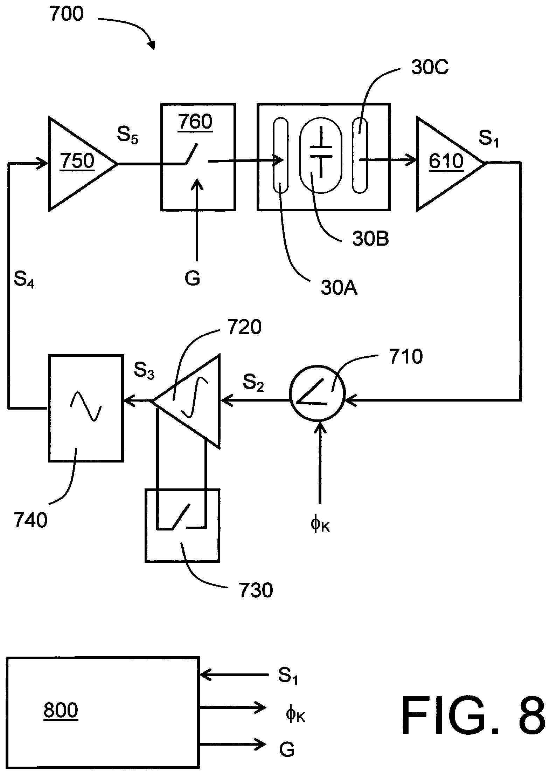

Measurements of resonance Q-factor of the coil **30B** are beneficially performed using a circuit as illustrated in FIG. 8. The circuit is indicated generally by **700** and includes a gated phase-locked-loop (PLL) including the aforesaid amplifier **610** for receiving a signal from the pickup coil **30C**, a phase detector **710** for receiving an output signal $S_1$ of the amplifier **610,** a phase integrator **720** for receiving a phase error output signal $S_2$ of the phase detector **710** wherein the phase integrator **720** is provided with an associated gating switch **730** for locking an output signal $S_3$ of the integrator **720** when required, a voltage-controlled oscillator (VCO) **740** controlled by the output signal $S_3$ of the phase integrator **720,** a drive amplifier **750** for receiving an output signal $S_4$ from the oscillator (VCO), and a switch **760** for receiving an output signal $S_5$ of the drive amplifier **750** and coupled to the excitation coil **30A**. There is also included a microprocessor **800** for providing a phase reference signal $\phi_K$ to the phase detector **710,** for providing a gating signals G to the switches **730, 760,** and for receiving the signal $S_1$. The microprocessor **800** is operable to execute software products recorded on machine-readable data storage media to generate an output indicative of water content as measured by the apparatus **10.**

The phase integrator **720** is implemented either by analog components or digitally, and is provided with the switch **730** for momentarily holding the output signal $S_3$ of the integrator **720** constant, thereby maintaining an output frequency of the signal $S_4$ momentarily constant. Optionally, the oscillator **740** synthesizes a sine-wave for the signal $S_4$ and its output is derived from a stable high-frequency reference, for example derived from a high-stability quartz-crystal oscillator forming a part of the oscillator **720.**

In operation, the circuit **700** functions in two modes, namely a first excitation mode and a second measurement mode. In the first excitation mode, the oscillator **730** is swept to find a driven resonance frequency $\omega_0$ of the coil **30B** and the phase signal $\phi_K$ is then adjusted by the microprocessor **800** so that the amplitude of the signal $S_1$ is adjusted to its maximum amplitude; this occurs with the switch **760** closed to couple the signal $S_5$ to the excitation coil **30A**. When a maximum amplitude for the signal $S_1$ is achieved, the coil **30B** is resonating at its driven resonance frequency $\omega_0$.

Thereafter, the circuit **700** is operated in its second mode, wherein the oscillator **730** is locked at the frequency $\omega_0$ via use of the switch **730** controlled from the microprocessor **800**; optionally, the oscillator **740** is adjusted slightly down in frequency to an estimate of its natural undriven resonant frequency $\omega_n$, namely when the coils **30A, 30C** are effectively open-circuit. The microprocessor **800,** via the switch **760,** then pulse excites the excitation coil **30A,** and hence excites the coil **30B,** using one or more pulses preferably at a frequency $\omega_n$ and thereafter opens the switch **760,** so that the coil **30B** exhibits a natural resonance at a frequency $\omega_n$ with a decay envelope akin to that illustrated in FIG. 3A and FIG. 3B from which a measure of Q-factor may be derived using the microprocessor **800** to digitize and analyze the signal $S_1$ during the decay envelope, for example as illustrated in FIG. 3A and FIG. 3B. The first mode followed by the second mode is beneficially implemented within a time period during which the noise source **600** on FIG. 7 is quasi-constant.

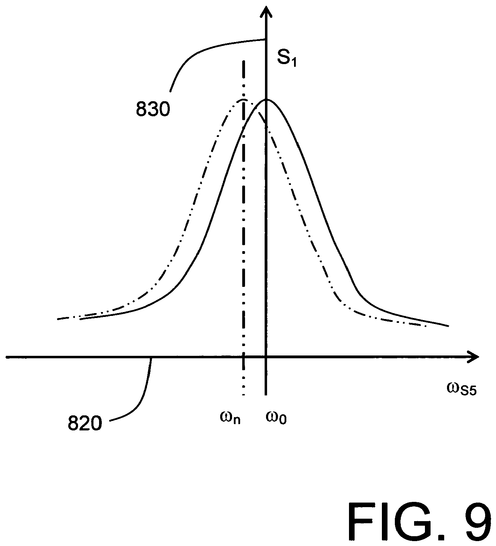

FIG. 9 illustrates a difference between the driven resonance frequency $\omega_0$ of the coil **30B** in comparison to the natural resonance frequency $\omega_n$. An amplitude of the signal $S_1$ is denoted along an ordinate axis **830** and the driving frequency of the signal $S_5$ is denoted along an abscissa axis **820**.

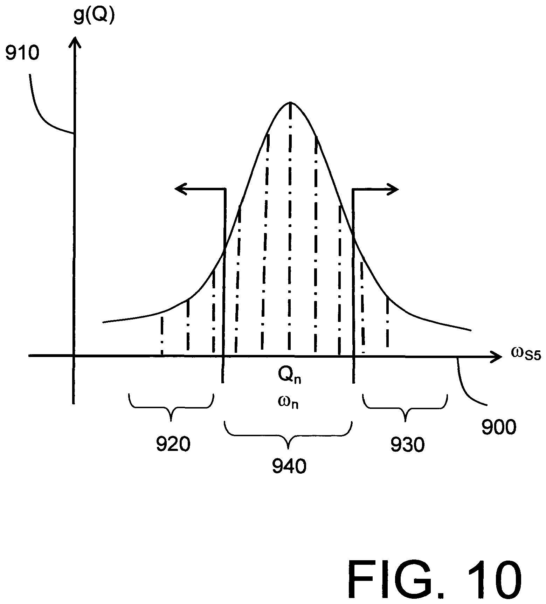

By repeating the first mode followed promptly by the second mode a plurality of times, a series of Q-factor measurements $Q_1, ... Q_m$ are obtained during a measurement time period. On account of turbulence noise arising within the tube **20** and electronic noise as aforementioned, the series of Q-factors fall generally within a Gaussian-bell frequency-of-occurrence distribution as illustrated in FIG. 10 as computed by the microprocessor **800**. An abscissa axis **900** denotes frequency of resonance as approximately determined from the signal $S_5$, and an ordinate axis **910** denotes a frequency-of-occurrence of given Q-factors in the sample of Q-factor $Q_1, ... Q_m$, denoted by g(Q). In the results illustrated, the microprocessor **800** determines a most representative Q-factor to employ for Equation 1 (Eq. 1) by performing analytical processing on the series of measured Q-factors $Q_1, ... Q_m$ as will now be described.

In signal processing performed by the microprocessor **800,** lower and upper results denoted by **920, 930** are beneficially ignore, namely truncated, and more central Q-factor results are in a region **940** are employed to derive a reliable measure of the Q-factor to employ for Equation 1 (Eq. 1). For example, the upper and lower results **920, 930** correspond to upper and lower quartiles of the Q-factor distribution of FIG. 10. In a first processing method, the results in the region **940** are averaged to derive a representative value of Q-factor at the natural resonant frequency $\omega_n$ of the coil **30B.** In an alternative second processing method, the Q-factor results in the region **940** are subject to one or more auto-correlations which defines very accurately a best measurement of Q-factor at an auto-correlation peak. By such an approach, the microprocessor **800** of the instrument **10** is capable of determining a representative value for the Q-factor of the coil **30B** to extreme precision, which subsequently enables water factions present in the tube **20** in vicinity of the coil **30B** to be measure to potentially p.p.m. accuracy using Equation 1 (Eq. 1).

In overview, the circuit **700** is beneficially operable to measure the Q-factor of the coil **30B** at natural resonance $\omega_n$, and then process corresponding Q-factor measurements to remove stochastic errors which, in turn, enables Equation 1 (Eq. 1) to be employed to high accuracy to determine a water faction present within the tube **20,** for example potentially to p.p.m. accuracy.

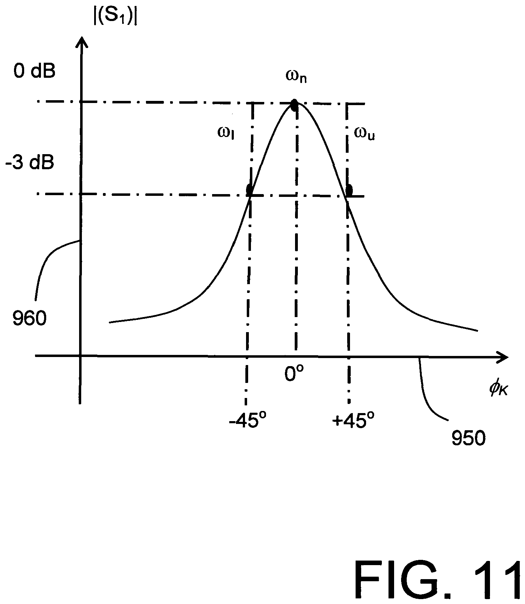

As an alternative, the circuit **700** is capable of being employed in other manners for measuring Q-factor of the coil **30B.** For example, the circuit **700** is adjusted to find a driven peak resonance of the coil **30B** at a frequency $\omega_0$, and then a phase adjustment provided by way of the phase control $\phi_K$ is applied by the microprocessor **800** to switch between phase intervals below and/or above resonance of the coil **30B,** for example corresponding to -3 dB points, and corresponding Q-factor measurements $Q_1, ... Q_m$ obtained which are then optionally processed as aforementioned to correct for stochastic influences to derive a final measure of the Q-factor to employ in Equation 1 (Eq. 1) for computing the water faction w present in the tube **20.** Such continuous non-pulse measurement is illustrated in FIG. 11 where an abscissa axis **950** denotes phase and an ordinate axis **960** denotes amplitude of the signal $S_1$, for example for -3 dB, 0 dB, -3 dB points corresponding to operating control phases of -45°, 0°, +45° respectively, corresponding to excitation frequencies $\omega_l$, $\omega_0$, $\omega_u$ respectively; a measure of Q-factor of the coil 30B can be computed readily from the frequencies $\omega_l$, $\omega_0$, $\omega_u$.

From the foregoing, it will be appreciated that operation of the instrument **10** to measure water content to an accuracy of p.p.m. requires that the coil **30B** be appropriately designed together with advanced signal processing techniques being employed to reduce error sources so that a highly reliable and accurate measurement of Q-factor can be derived from which the water fraction w present can be accurately and reliably computed.

Modifications to embodiments of the invention described in the foregoing are possible without departing from the scope of the invention as defined by the accompanying claims. Expressions such as "including", "comprising", "incorporating", "consisting of", "have", "is" used to describe and claim the present invention are intended to be construed in a non-exclusive manner, namely allowing for items, components or elements not explicitly described also to be present. Reference to the singular is also to be construed to relate to the plural. Numerals included within parentheses in the accompanying claims are intended to assist understanding of the claims and should not be construed in any way to limit subject matter claimed by these claims.

**Claims**

1. A water content measuring apparatus (10) for measuring water content present in a fluid flow through a tube (20), wherein the apparatus (10) includes a generator (50) for generating in operation a pulsed excitation signal (60), a coil arrangement (30A, 30B, 30C) disposed around the tube (20) adapted to be excited into resonance by the excitation signal (60) and interact with the fluid flow through the tube (20), and a signal processor (80) adapted to receive resonance signals from the coil arrangement (30A, 30B, 30C) for determining a water content present within the tube (20), wherein the coil arrangement (30A, 30B, 30C) includes a resonance coil (30B) having a length-to-diameter ratio which is at least 3:1, wherein the resonance coil (30B) includes at least 10 turns, and wherein the generator (50) is adapted to generate pulses having a pulse duration much shorter than a period between pulses.

2. A water content measuring apparatus (10) as claimed in claim 1, wherein said generator (50) is arranged to generate the excitation signal to be a temporal series of excitation pulses.

3. A water content measuring apparatus (10) as claimed in claim 1 or 2, wherein the tube (20) and its associated coil arrangement (30A, 30B, 30C) are surrounded by an electrostatic shield (40) for screening the coil arrangement (30A, 30B, 30C) when in operation.

4. A water content measuring apparatus (10) as claimed in claim 1, 2 or 3, further including a sensor arrangement (100) for sensing low-frequency electrical conductivity and temperature on an inside wall of the tube (20) and for providing corresponding sensor signals to the data processor (80) for enabling the signal processor (80) to compute the water content within the tube (20) independently of the salinity of the water content.

**5.** A water content measuring apparatus (10) as claimed in claim 1, 2, 3 or 4, wherein the coil arrangement (30) includes excitation, resonance and pickup coils (30A, 30B, 30C), wherein the excitation coil (30A) is coupled to the generator (50), the pickup coil (30B) is coupled to the signal processor (80), and the resonance coil (30B) is coupled to a tuning capacitor (C) for providing a resonance characteristic which is sensitive to water content within the tube (20).

**6.** A water content measuring apparatus (10) as clamed in claim 5, wherein the coils (30A, 30B, 30C) are fabricated from at least one of: individually insulated Litz wires, insulated metallic tape.

**7.** A water content measuring apparatus (10) as claimed in any one of the preceding claims, wherein at least one of the generator (50) and the signal processor (80) are adapted to be spatially remote from the tube (20) and its coil arrangement (30A, 30B, 30C) in operation.

**8.** A water content measuring apparatus (10) as claimed in any one of the preceding claims, wherein the tube (20) is fabricated from at least one of: polycarbonate polymer, acrylic polymer, PEEK.

**9.** A method of operating a water content measuring apparatus (10) as claimed in any one of the preceding claims, wherein the apparatus (10) is adapted to monitor conditions for potential hydrate formation within the tube (20), and wherein detection of minute quantities of water present within the tube is indicative of potential early hydrate formation.

**10.** A method of measuring water content present in a fluid flow through a tube (20), **characterized in that** the method includes:

(a) using a generator (50) to generate in operation a pulsed excitation signal (60) for exciting a coil arrangement (30A, 30B, 30C) disposed around the tube (20) for interacting with the fluid flow through the tube (20); and
(b) receiving at a signal processor (80) resonance signals from the coil arrangement (30A, 30B, 30C) for determining a water content present within the tube (20), wherein the coil arrangement (30A, 30B, 30C) includes a resonance coil (30B) having a length-to-diameter ratio which is at least 3:1, wherein the resonance coil (30B) include at least 10 turns;

and wherein the pulses have a pulse duration much shorter than a period between pulses

**11.** A software product recorded on a machine readable medium, wherein the software product is executable upon computing hardware (80; 800) for implementing a method as claimed in claim 10.

**Patentansprüche**

**1.** Wassergehalt-Messvorrichtung (10) zum Messen eines Wassergehalts, der in einem Fluidstrom durch ein Rohr (20) vorhanden ist, wobei die Vorrichtung (10) einen Erzeuger (50) zum Erzeugen eines gepulsten Anregungssignals (60) im Betrieb, eine Spulenanordnung (30A, 30B, 30C), die um das Rohr (20) angeordnet ist und dazu ausgelegt ist, durch das Anregungssignal (60) in eine Resonanz angeregt zu werden und mit dem Fluidstrom durch das Rohr (20) in Wechselwirkung zu treten, und einen Signalprozessor (80), der dazu ausgelegt ist, Resonanzsignale von der Spulenanordnung (30A, 30B, 30C) zum Bestimmen eines Wassergehalts, der innerhalb des Rohrs (20) vorhanden ist, zu empfangen, enthält, wobei die Spulenanordnung (30A, 30B, 30C) eine Resonanzspule (30B) enthält, die ein Verhältnis der Länge zu dem Durchmesser besitzt, das mindestens 3:1 beträgt, wobei die Resonanzspule (30B) mindestens 10 Windungen umfasst und wobei der Erzeuger (50) dazu ausgelegt ist, Pulse zu erzeugen, die eine Pulsdauer besitzen, die viel kürzer als eine Periode zwischen Pulsen ist.

**2.** Wassergehalt-Messvorrichtung (10) nach Anspruch 1, wobei der Erzeuger (50) dazu ausgelegt ist, das Anregungssignal als eine zeitliche Reihe von Anregungspulsen zu erzeugen.

**3.** Wassergehalt-Messvorrichtung (10) nach Anspruch 1 oder 2, wobei das Rohr (20) und seine zugeordnete Spulenanordnung (30A, 30B, 30C) im Betrieb durch eine elektrostatische Abschirmung (40) zum Abschirmen der Spulenanordnung (30A, 30B, 30C) umgeben sind.

**4.** Wassergehalt-Messvorrichtung (10) nach Anspruch 1, 2 oder 3, die ferner eine Sensoranordnung (100) zum Erfassen einer elektrischen Leitfähigkeit für niedrige Frequenzen und einer Temperatur auf einer Innenwand des Rohrs (20) und zum Bereitstellen von entsprechenden Sensorsignalen für den Datenprozessor (80), um dem Signalprozessor (80) zu ermöglichen, den Wassergehalt innerhalb des Rohrs (20) unabhängig von dem Salzgehalt des Wassergehalts zu berechnen, enthält.

5. Wassergehalt-Messvorrichtung (10) nach Anspruch 1, 2, 3 oder 4, wobei die Spulenanordnung (30) eine Anregungsspule, eine Resonanzspule und eine Abnahmespule (30A, 30B, 30C) enthält, wobei die Anregungsspule (30A) an den Erzeuger (50) gekoppelt ist, die Abnahmespule (30B) an den Signalprozessor (80) gekoppelt ist und die Resonanzspule (30B) an einen Abstimmkondensator (C) zum Bereitstellen einer Resonanzeigenschaft, die auf den Wassergehalt innerhalb des Rohrs (20) empfindlich reagiert, gekoppelt ist.

6. Wassergehalt-Messvorrichtung (10) nach Anspruch 5, wobei die Spulen (30A, 30B, 30C) aus einzeln isolierten Litzen und/oder einem isolierten metallischen Band hergestellt sind.

7. Wassergehalt-Messvorrichtung (10) nach einem der vorhergehenden Ansprüche, wobei der Erzeuger (50) und/oder der Signalprozessor (80) dazu ausgelegt sind, im Betrieb von dem Rohr (20) und seiner Spulenanordnung (30A, 30B, 30C) räumlich entfernt zu sein.

8. Wassergehalt-Messvorrichtung (10) nach einem der vorhergehenden Ansprüche, wobei das Rohr (20) aus Polycarbonat-Polymer und/oder Acrylpolymer und/oder PEEK hergestellt ist.

9. Verfahren zum Betreiben einer Wassergehalt-Messvorrichtung (10) nach einem der vorhergehenden Ansprüche, wobei die Vorrichtung (10) dazu ausgelegt ist, Bedingungen für eine potentielle Hydratbildung innerhalb des Rohrs (20) zu überwachen und
wobei eine Detektion von sehr kleinen Mengen von Wasser, das innerhalb des Rohrs vorhanden ist, auf eine potentielle frühe Hydratbildung hinweist.

10. Verfahren zum Messen eines Wassergehalts, der in einem Fluidstrom durch ein Rohr (20) vorhanden ist, **dadurch gekennzeichnet, dass** das Verfahren Folgendes umfasst:

(a) Verwenden eines Erzeugers (50), um im Betrieb ein gepulstes Anregungssignal (60) zum Anregen einer Spulenanordnung (30A, 30B, 30C), die für eine Wechselwirkung mit dem Fluidstrom durch das Rohr (20) um das Rohr (20) angeordnet ist, zu erzeugen; und
(b) Empfangen von Resonanzsignalen von der Spulenanordnung (30A, 30B, 30C) bei einem Signalprozessor (80) zum Bestimmen eines Wassergehalts, der innerhalb des Rohrs (20) vorhanden ist, wobei die Spulenanordnung (30A, 30B, 30C) eine Resonanzspule (30B) enthält, die ein Verhältnis der Länge zu dem Durchmesser besitzt, das mindestens 3:1 beträgt, wobei die Resonanzspule (30B) mindestens 10 Windungen umfasst;

und wobei die Pulse eine Pulsdauer besitzen, die viel kürzer als eine Periode zwischen Pulsen ist.

11. Softwareprodukt, das auf einem maschinenlesbaren Medium aufgezeichnet ist, wobei das Softwareprodukt dann ausgeführt werden kann, wenn Hardware (80; 800) zum Implementieren eines Verfahrens nach Anspruch 10 berechnet wird.

## Revendications

1. Appareil de mesure de teneur en eau (10) servant à mesurer la teneur en eau dans un débit de fluide circulant dans un tube (20), l'appareil (10) comprenant un générateur (50) servant à générer, en fonctionnement, un signal d'excitation à impulsions (60), un agencement de bobines (30A, 30B, 30C) disposé autour du tube (20) et conçu pour être excité en résonance par le signal d'excitation (60) et interagir avec le débit de fluide circulant dans le tube (20), et un processeur de signal (80) conçu pour recevoir des signaux de résonance de l'agencement de bobines (30A, 30B, 30C) pour déterminer une teneur en eau présente à l'intérieur du tube (20), l'agencement de bobines (30A, 30B, 30C) comprenant une bobine de résonance (30B) ayant un rapport longueur-diamètre qui est au moins égal à 3:1, la bobine de résonance (30B) comprenant au moins 10 tours, et dans lequel appareil
le générateur (50) est conçu pour générer des impulsions ayant une durée d'impulsion bien inférieure à une période entre impulsions.

2. Appareil de mesure de teneur en eau (10) selon la revendication 1, dans lequel ledit générateur (50) est agencé pour générer le signal d'excitation de telle façon que celui-ci soit une série temporelle d'impulsions d'excitation.

**3.** Appareil de mesure de teneur en eau (10) selon la revendication 1 ou 2, dans lequel le tube (20) et son agencement de bobines (30A, 30B, 30C) associé sont entourés par un blindage électrostatique (40) servant à blinder l'agencement de bobines (30A, 30B, 30C) pendant le fonctionnement.

**4.** Appareil de mesure de teneur en eau (10) selon la revendication 1, 2 ou 3, comprenant également un agencement de capteurs (100) servant à détecter la conductivité électrique à basse fréquence et la température sur une paroi intérieure du tube (20) et à fournir des signaux de capteur correspondants au processeur de données (80) pour permettre au processeur de signal (80) de calculer la teneur en eau à l'intérieur du tube (20), indépendamment de la salinité de la teneur en eau.

**5.** Appareil de mesure de teneur en eau (10) selon la revendication 1, 2, 3 ou 4, dans lequel l'agencement de bobines (30) comprend des bobines d'excitation, de résonance et de détection (30A, 30B, 30C), la bobine d'excitation (30A) étant couplée au générateur (50), la bobine de détection (30B) étant couplée au processeur de signal (80) et la bobine de résonance (30B) étant couplée à un condensateur d'accord (C) servant à produire une caractéristique de résonance qui est sensible à la teneur en eau à l'intérieur du tube (20).

**6.** Appareil de mesure de teneur en eau (10) selon la revendication 5, dans lequel les bobines (30A, 30B, 30C) sont fabriquées dans au moins un des matériaux suivants : fils de Litz isolés individuellement, ruban métallique isolé.

**7.** Appareil de mesure de teneur en eau (10) selon l'une quelconque des revendications précédentes, dans lequel au moins le générateur (50) ou le processeur de signal (80) est conçu pour être spatialement distant du tube (20) et de son agencement de bobines (30A, 30B, 30C) pendant le fonctionnement.

**8.** Appareil de mesure de teneur en eau (10) selon l'une quelconque des revendications précédentes, dans lequel le tube (20) est fabriqué dans au moins un des matériaux suivants : polymère de polycarbonate, polymère acrylique, PEEK.

**9.** Procédé d'utilisation d'un appareil de mesure de teneur en eau (10) selon l'une quelconque des revendications précédentes, dans lequel l'appareil (10) est conçu pour surveiller les conditions pour la formation potentielle d'hydrates à l'intérieur du tube (20), et
dans lequel la détection de quantités minuscules d'eau présentes à l'intérieur du tube indique un début de formation potentielle d'hydrates.

**10.** Procédé de mesure de la teneur en eau présente dans un débit de fluide circulant dans un tube (20), le procédé étant **caractérisé en ce qu'**il comprend :

(a) l'utilisation d'un générateur (50) servant à générer, pendant le fonctionnement, un signal d'excitation à impulsions (60) servant à exciter un agencement de bobines (30A, 30B, 30C) disposé autour du tube (20) pour interagir avec le débit de fluide circulant dans le tube (20), et
(b) la réception, au niveau d'un processeur de signal (80), de signaux de résonance provenant de l'agencement de bobines (30A, 30B, 30C) et servant à déterminer une teneur en eau présente à l'intérieur du tube (20), l'agencement de bobines (30A, 30B, 30C) comprenant une bobine de résonance (30B) ayant un rapport longueur-diamètre qui est au moins égal à 3:1, la bobine de résonance (30B) comprenant au moins 10 tours ;

et dans lequel appareil les impulsions ont une durée d'impulsion bien inférieure à une période entre impulsions.

**11.** Produit logiciel enregistré sur un support lisible par machine, le produit logiciel pouvant être exécuté sur un matériel informatique (80 ; 800) pour mettre en oeuvre un procédé selon la revendication 10.

FIG. 1

$Q, T, \sigma, P$

$f_d, \tau_p$

80, 90

50

20, 30A,
30B,
30C, 100

30A

60

50 Ω    33 Ω

1000pF

# FIG. 2

# FIG. 3A

# FIG. 3B

FIG. 4

**FIG. 5**

FIG. 6

FIG. 7

FIG. 8

FIG. 9

FIG. 10

FIG. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004025288 A1

- WO 03050529 A